(19)

Europäisches
Patentamt
European
Patent Office
Office européen
des brevets

(11) **EP 4 310 687 A1**

(12) **EUROPEAN PATENT APPLICATION**
published in accordance with Art. 153(4) EPC

(43) Date of publication:
**24.01.2024 Bulletin 2024/04**

(21) Application number: **22790688.0**

(22) Date of filing: **09.02.2022**

(51) International Patent Classification (IPC):
***G06F 15/163*** *(2006.01)*

(52) Cooperative Patent Classification (CPC):
**G06F 13/42; G06F 15/163; G06N 3/08; G06Q 30/06**

(86) International application number:
**PCT/CN2022/075620**

(87) International publication number:
**WO 2022/222578 (27.10.2022 Gazette 2022/43)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.04.2021 CN 202110431626**

(71) Applicant: **Huawei Technologies Co., Ltd.
Shenzhen, Guangdong 518129 (CN)**

(72) Inventor: **DUAN, Qihang
Shenzhen, Guangdong 518129 (CN)**

(74) Representative: **Isarpatent
Patent- und Rechtsanwälte
Barth Hassa Peckmann & Partner mbB
Friedrichstraße 31
80801 München (DE)**

(54) **AGGREGATION COMMUNICATION METHOD AND SYSTEM, AND COMPUTER DEVICE**

(57) This application discloses a collective communication method and system, and a computer device. The method is applied to the collective communication system. The system includes at least a first computing chip and a second computing chip. The first computing chip communicates with the second computing chip through at least one communication channel. The method includes: The first computing chip compresses first data and sends compressed first data to the second computing chip through the communication channel. The second computing chip performs an operation based on the compressed first data. This improves efficiency of collective communication.

S401. A to-be-communicated computing chip compresses a to-be-communicated matrix

↓

S402. Establish a communication channel between to-be-communicated computing chips

↓

S403. A processor 110 determines a root node from the to-be-communicated computing chip

↓

S404. The root node receives data of another to-be-communicated computing chip, and obtains a collective operation result

FIG. 4

EP 4 310 687 A1

**Description**

This application claims priority to Chinese Patent Application No. 202110431626.8, filed with the China National Intellectual Property Administration on April 21, 2021 and entitled "COLLECTIVE COMMUNICATION METHOD AND SYSTEM, AND COMPUTER DEVICE", which is incorporated herein by reference in its entirety.

**TECHNICAL FIELD**

This application relates to the computer field, and in particular, to a collective communication method and system, and a computer device.

**BACKGROUND**

With advent of the internet personalization era, when a purchase intention of a user is unclear, a recommendation algorithm can be used for finding merchandise in which the user is interested from a large amount of merchandise by using a deep learning algorithm with reference to a user feature and a merchandise feature, so that user purchase efficiency and product experience are improved. Therefore, the recommendation algorithm has become a profit core of a plurality of internet head enterprises. The recommendation algorithm usually uses a plurality of GPUs to complete a computing task in parallel, and migrates data among a plurality of processors by using a collective communication technology. Currently, NVIDIA® has introduced two sets of hardware systems: DGX-1® and DGX-2®, and a GPU collective communication library NCCL® that is compatible with the hardware systems, to support collective communication between GPUs. However, in actual application, because data of a user feature and data of a merchandise feature include a large amount of data with a value of 0 and having extremely high sparseness, there is a large amount of invalid transmission of 0 in an existing collective communication technology for sparse data. This reduces communication efficiency. Therefore, how to provide a method for improving collective communication efficiency of sparse data becomes a technical problem to be urgently resolved.

**SUMMARY**

This application provides a collective communication method and system, and a computer device, to provide a method for an efficient collective communication of sparse data, and improve a capability of the collective communication system for processing an algorithm that needs to complete data transmission among a plurality of computing chips.

According to a first aspect, a collective communication method is provided, and may be applied to a collective communication system. The system includes at least a first computing chip and a second computing chip. The first computing chip communicates with the second computing chip through at least one communication channel. The method includes: The first computing chip compresses first data and sends compressed first data to the second computing chip through the communication channel. Then the second computing chip performs an operation based on the compressed first data. According to the foregoing method, the first computing chip may compress original data and send compressed original data to the second chip. This reduces an amount of data transmitted between the first chip and the second chip.

In a possible implementation, the first computing chip communicates with the second computing chip through one communication channel. The second computing chip is a root node of the communication channel. A method for performing an operation by the second computing chip based on the compressed first data may include: The second computing chip aggregates the compressed first data with second data, where the second data is to-be-communicated data on the second computing chip. The second computing chip sends an aggregation result to the first computing chip. According to the foregoing method, the first chip may send compressed data to the second computing chip through one channel, and the second chip aggregates the data and sends the data back to the first chip, to obtain a result of an all-reduce operation in collective communication, and increase execution time of the all-reduce operation.

In another possible implementation, the collective communication system further includes a processor. The first computing chip communicates with the second computing chip through one communication channel. The second computing chip is a root node of the communication channel. The method includes: The first computing chip compresses the first data. The second computing chip compresses the second data. The processor obtains sizes of the compressed first data and compressed second data, and invokes an all-gather interface in an NCCL® communication library to send the compressed first data to the second computing chip, and sends the compressed second data to the first computing chip. Finally, the first computing chip aggregates the compressed second data with the first data; the second computing chip aggregates the compressed first data with the second data. According to the foregoing method, the processor may invoke an interface in an existing communication library to complete the all-reduce operation. This improves efficiency of the all-reduce operation without changing a large quantity of code.

In another possible implementation, the first computing chip also communicates with the second computing chip through one communication channel. The second computing chip is a root node of the communication channel. A method for performing an operation by the second computing chip based on the compressed first data may include: The second computing chip combines the compressed first data and the second data, where the second data is to-be-communicated data on the second computing chip; and the second computing chip sends an aggregation result to the first computing chip. According to the foregoing method, the first chip may send compressed data to the second computing chip through one channel, and the second chip combines the data and sends the data back to the first chip, to obtain a result of an all-gather operation in collective communication, and increase execution time of the all-gather operation.

In another possible implementation, the first computing chip communicates with the second computing chip through a plurality of communication channels. The plurality of communication channels include a first communication channel. A method for sending, by the first computing chip, the compressed first data to the second computing chip through the communication channels may include: The first computing chip sends a first part of the first data to the second computing chip through the first communication channel. The second computing chip is a root node of the first communication channel. A method for performing an operation by the second computing chip based on the compressed first data may include: The second computing chip aggregates a part data of the compressed first data with a part of the second data, where the second data is to-be-communicated data on the second computing chip. According to the foregoing method, the first computing chip may send the compressed data to a root node of each channel through each of the plurality of channels. When a root node of one channel is the second computing chip, the first computing chip sends the compressed data to the second computing chip through the channel. The second computing chip aggregates the data to obtain a result of a reduce-scatter operation in collective communication, and increase execution time of the reduce-scatter operation.

In another possible implementation, the collective communication system may be configured to recommend merchandise to a user by using a recommendation model with reference to a user feature and a merchandise feature. Before the first computing chip compresses the first data, the method includes: The first processing chip converts the user feature and the merchandise feature into the first data based on an embedding table. The method further includes: The second computing chip inputs, into the recommendation model, an operation result obtained by the second computing chip by performing an operation based on the compressed first data, to obtain an updated value of the embedding table and an updated value of the recommendation model. The second computing chip updates the recommendation model based on the updated value of the recommendation model, and updates the embedding table based on the updated value of the embedding table. According to the foregoing method, the collective communication method provided in this application may be used to recommend the merchandise to the user with reference to the recommendation model. When an input value of the recommendation model is obtained based on the embedding table, data transmission efficiency between the first computing chip and the second computing chip is improved, and time for recommending the merchandise to the user is reduced.

In another possible implementation, the collective communication system may be configured to recommend merchandise to a user by using a recommendation model with reference to a user feature and a merchandise feature. Before the first computing chip compresses the first data, the method includes: The first processing chip converts the user feature and the merchandise feature into fourth data based on an embedding table. Then, the second computing chip inputs the fourth data into the recommendation model, to obtain the first data and an updated value of the recommendation model. The method further includes: The second computing chip updates the recommendation model based on the updated value of the recommendation model, and updates the embedding table based on an operation result obtained by the second computing chip by performing an operation based on the compressed first data. According to the foregoing method, the collective communication method provided in this application may be used to recommend the merchandise to the user with reference to the recommendation model. In an operation of updating the embedding table, data transmission efficiency between the first computing chip and the second computing chip is improved, and time for recommending the merchandise to the user is reduced.

In another possible implementation, the collective communication system may be configured to recommend merchandise to a user by using a recommendation model with reference to a user feature and a merchandise feature. Before the first computing chip compresses the first data, the method includes: The first processing chip converts the user feature and the merchandise feature into a query vector based on an embedding table, compresses the query vector, and then obtains the first data based on compressed query vector. The method further includes: The second computing chip obtains an embedding vector based on an operation result obtained by the second computing chip by performing an operation based on the compressed first data, and inputs the embedding vector into the recommendation model, to obtain an updated value of the embedding table and an updated value of the recommendation model. The second computing chip updates the recommendation model based on the updated value of the recommendation model, and updates the embedding table based on the updated value of the embedding table and the compressed query vector. According to the foregoing method, transmission time of the first data can be further reduced, and collective communication efficiency can be improved.

In another possible implementation, an amount of data whose value is 0 is greater than an amount of data whose value is not 0 in the first data. According to the foregoing method, invalid transmission of 0 in data may be effectively reduced, and communication efficiency may be improved.

In another possible implementation, the computing chip includes one or more of a graphics processing unit, a tensor processing unit, a neural network processing unit, and a deep learning processing unit.

According to a second aspect, this application provides a collective communication system, including at least a first computing chip and a second computing chip. The first computing chip communicates with the second computing chip through at least one communication channel. The collective communication system is configured to implement operation steps of the method performed by a corresponding entity according to the first aspect and any one of the possible implementations of the first aspect.

According to a third aspect, this application provides a computer device. The computer device includes a processor, a memory, a first computing chip, and a second computing chip. The memory is configured to store computer-executable instructions. When the computer device runs, the processor executes the computer-executable instructions in the memory, to perform operation steps of the method according to the first aspect or any one of the possible implementations of the first aspect by using the first computing chip and the second computing chip.

According to a fourth aspect, this application provides a computer-readable storage medium. The computer-readable storage medium stores instructions. The instructions, when being run on a computer, cause the computer to perform operation steps of the method according to the first aspect or any one of the possible implementations of the first aspect.

According to a fifth aspect, this application provides a computer program product including instructions. The computer program product, when runs on a computer, causes the computer to perform operation steps of the method according to the first aspect or any one of the possible implementations of the first aspect.

Based on the implementations provided in the foregoing aspects, this application may be further combined to provide more implementations.

**BRIEF DESCRIPTION OF DRAWINGS**

FIG. 1 is a schematic diagram of a structure of a collective communication system 100 according to an embodiment of this application;
FIG. 2 is a schematic diagram of a data flow of a data migration operation according to this application;
FIG. 3 is a schematic diagram of a data flow of a collective operation according to this application;
FIG. 4 is a schematic flowchart of a collective communication method according to this application;
FIG. 5 is a schematic flowchart of another collective communication method according to this application;
FIG. 6 is a schematic flowchart of another collective communication method according to this application;
FIG. 7 is a schematic flowchart of another collective communication method according to this application;
FIG. 8 is a schematic flowchart of another collective communication method according to this application; and
FIG. 9 is a schematic flowchart of another collective communication method according to this application.

**DESCRIPTION OF EMBODIMENTS**

The following describes technical solutions in embodiments of this application with reference to the accompanying drawings.

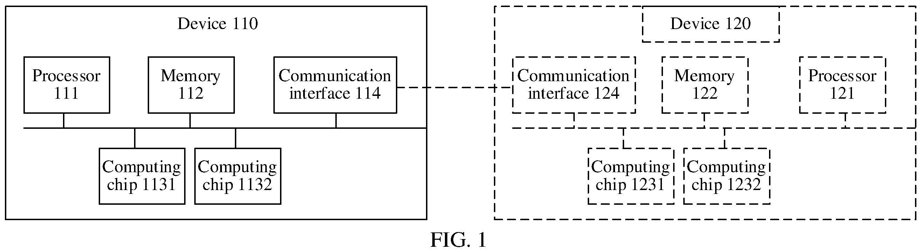

FIG. 1 is a schematic diagram of a structure of a collective communication system 100 according to an embodiment of this application. As shown in the figure, the system 100 includes a device 110. The device 110 may be a device (for example, a server) with a computing function, and is configured to independently complete a computing task involved in deep learning. The device 110 includes a processor 111, a memory 112, a communication interface 114, and at least two computing chips, for example, a computing chip 1131 and a computing chip 1132.

In the device 110, the processor 111, the memory 112, the communication interface 114, and all GPUs are connected through a bus, for example, peripheral component interconnect express (Peripheral Component Interconnect Express, PCIe). The bus may also be another type of bus that implements connection between components in the device. In addition, in addition to a data bus, the bus may further include a power bus, a control bus, a status signal bus, and the like. Computing chips may also be interconnected through NVLink® bus proposed by NVIDIA®.

The processor 111 is configured to execute computer-executable instructions stored in the memory 112, to implement a function of the device 110. For example, the processor 111 may be a CPU, or may be another general-purpose processor, a digital signal processor (digital signal processor, DSP), an application specific integrated circuit (application specific integrated circuit, ASIC), a field-programmable gate array (field-programmable gate array, FPGA), or another programmable logic devices, a discrete gate or a transistor logic device, a discrete hardware component, or the like. The general-purpose processor may be a microprocessor, any conventional processor, or the like.

The memory 112 may include a read-only memory and a random access memory, and provide instructions and data to the processor 111. The memory 112 may further include a non-volatile random access memory.

The memory 112 may also be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which is used as an external cache. Through illustrative but not limited description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The computing chip is a processor suitable for performing a deep learning algorithm, for example, a graphics processing unit (graphics processing unit, GPU), a tensor processing unit (tensor processing unit, TPU), a neural network processing unit (neural network processing unit, NPU), or a deep learning processing unit (deep learning processing unit, DPU). It should be noted that the device 110 may include at least two computing chips of a same type or different types. For example, as shown in FIG. 1, the device 110 may include two GPUs (a graphics processing unit 1131 and a graphics processing unit 1132), or may include two NPUs, or may include one GPU and one NPU. A plurality of computing chips may concurrently perform a deep learning related algorithm, for example, training and inference of a neural network, and data transmission may be completed between computing chips through a bus by using a collective communication technology.

Optionally, the system 100 may further include a plurality of devices, such as the device 110 and the device 120. Another device has a similar structure to the device 110. Different devices of the system 100 communicate with each other over a network. The network includes a wired or wireless transmission manner. The wired transmission manner includes use of an Ethernet, an optical fiber, or the like of forms for data transmission, and the wireless transmission manner includes a transmission manner such as a mobile hotspot (Wi-Fi), Bluetooth, and infrared. In a specific implementation process, one or more switches and/or routers may be used to implement communication processing among a plurality of nodes.

When the system 100 includes a plurality of devices, the device 110 may collaborate with another device to complete a computing task involved in deep learning. In this case, the device 110 may include the processor 111, the memory 112, the communication interface 114, and at least one computing chip. Computing chips of different devices may concurrently perform a deep learning-related algorithm. Data transmission is completed between computing chips in a same device through the bus by using the collective communication technology. Data transmission is completed between computing chips of different devices through the network by using the collective communication technology.

It should be noted that a management system architecture of a computing resource shown in FIG. 1 is merely an example of a system architecture provided in a management method of the computing resource provided in this application, and does not constitute a limitation on this embodiment of this application.

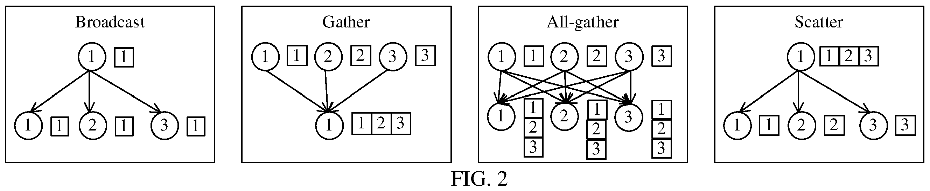

Next, based on the system shown in FIG. 1, the collective communication method provided in this application is further described in detail with reference to FIG. 2 to FIG. 9. There are three types of operations for collective communication: a barrier (barrier), data migration, and a collective operation.

The barrier operation is used for synchronizing all processes in a communicator. Execution of processes in barrier operation can be continued only after the barrier operation of all the processes are completed.

The data migration operation is used for sending data in a process to another process in the communicator, and further includes broadcast (broadcast), gather (gather), all-gather (all-gather), and scatter (scatter). FIG. 2 is a schematic diagram of a data flow of a data migration operation according to this application. As shown in the figure, the first section from the left is broadcast. Data 1 of node 1 may be sent to the node 1 and the node 2 respectively. The second section from the left is the gather. All the data 1 of the node 1, data 2 of the node 2, and data 3 of node 3 may be sent to the node 1. The third section from the left is all-gather. The data 1 of the node 1 may be sent to the node 2 and the node 3 respectively, the data 2 of the node 2 is sent to the node 1 and the node 3 respectively, and the data 3 of the node 3 is sent to the node 1 and the node 2 respectively. Finally, each of the nodes 1 to 3 has the data 1 to 3. The fourth section from the left on the left is scatter. The data 2 of the node 1 may be sent to the node 2, and the data 3 may be sent to the node 3.

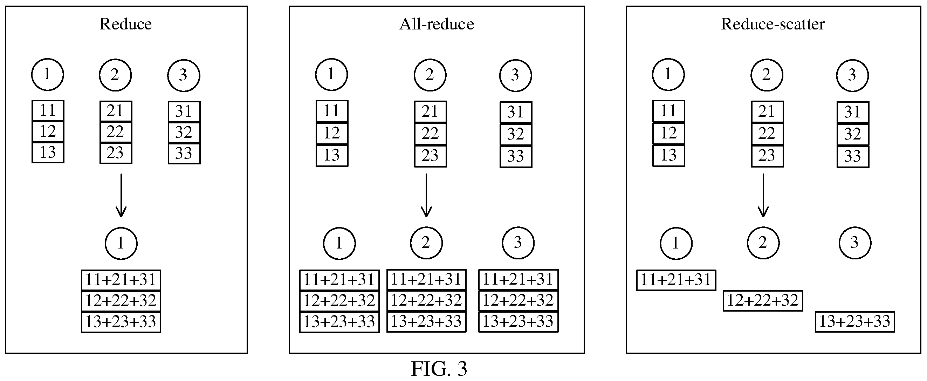

The collective operation is used for implementing a data arithmetic operation, such as solving minimum and maximum values, summing, a logical AND operation, and another user-defined calculation algorithm. The collective operation includes reduce (reduce), all-reduce (all-reduce), and reduce-scatter (reduce-scatter). FIG. 3 is a schematic diagram of a data flow of a collective operation according to this application. That an arithmetic operation is a summation is used as an example. As shown in the figure, the first section from the left is reduce. Data of node 1, node 2, and node 3 is respectively added and stored in the node 1. The second section from the left is all-reduce, which can be considered as reduce plus broadcast, and a reduce result of the node 1 is sent to all other nodes. The third section from the left is reduce-scatter, which may be considered as reduce plus scatter. Finally, the data of the node 1 is a sum of a first piece of data of the node 1 to the node 3, the data of the node 2 is a sum of second data of the node 1 to the node 3, and the data of the node 3 is a sum of third piece of data of the node 1 to the node 3.

In a recommendation algorithm, the following collective communication methods are widely used: reduce-scatter, all-reduce, and all-gather. Therefore, this application separately provides a reduce-scatter method, an all-reduce method, and an all-gather method that are applicable to a sparse matrix collective communication method, and combines these methods with the recommendation algorithm. It should be noted that the collective communication method provided in this application is also applicable to a scenario in which sparse data collective communication is performed in another algorithm.

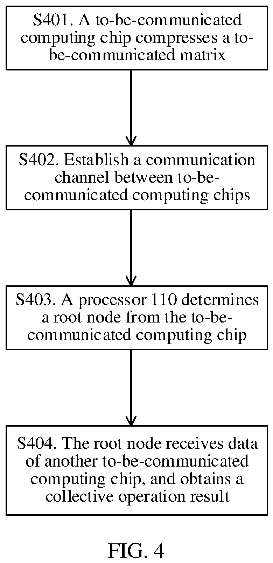

FIG. 4 is a schematic flowchart of a collective communication method according to this application. Specifically, a reduce-scatter operation can be completed. The method may be performed by the device 110 shown in FIG. 1, or may be jointly performed by the device 110 shown in FIG. 1 and another device. The following describes a procedure of the method by using an example in which the device 110 independently performs the method. As shown in FIG. 4, a specific method includes the following steps.

S401. A to-be-communicated computing chip compresses a to-be-communicated matrix.

A processor 111 on the device 110 delivers instructions to indicate the to-be-communicated computing chip to compress the to-be-communicated matrix on the to-be-communicated computing chip. A compression manner may be a matrix compression manner mastered by a person skilled in the art, for example, any one of the following compression manners may be used.

Manner 1: Row compression.

In the row compression, an original matrix is compressed, to obtain a compression matrix (row matrix) and a compression vector (row offset). The compression vector records a row number of a non-zero row and a total row number of a matrix. The compression matrix records data of a non-zero row corresponding to a row number. For example, for

a matrix $A = \begin{pmatrix} 1 & 2 & 3 \\ 0 & 0 & 0 \\ 0 & 0 & 0 \\ 7 & 6 & 5 \\ 0 & 0 & 0 \\ 5 & 5 & 5 \\ 0 & 0 & 0 \end{pmatrix}$, a compression matrix obtained through the row compression is $B = \begin{pmatrix} 1 & 2 & 3 \\ 7 & 6 & 5 \\ 5 & 5 & 5 \end{pmatrix}$ and the compression vector is (0 3 5 7). 0 represents a row number corresponding to a row 1 of data (1 2 3) in a vector matrix. Similarly, 3 and 5 respectively represent row numbers corresponding to a row 2 and a row 3 of data in the vector matrix, and 7 represents that a total row number of the original matrix is 7. The row compression manner is lossless compression. Compressed data may be stored consecutively or separately.

Manner 2: coordinate list (coordinate list, COO) compression.

In the COO compression manner, a non-zero element in each original matrix is represented by a triplet. The triplet includes three vectors: a row number vector, a column number vector, and a numeric vector. The row number vector stores a row number of the non-zero element, the column number vector stores a column number of the non-zero element, and the numeric vector stores a numerical value of the non-zero element. Data locations in the three vectors are in a one-to-one correspondence. For example, for a matrix $C = \begin{pmatrix} 0 & 0 & 1 \\ 2 & 0 & 0 \\ 0 & 3 & 4 \end{pmatrix}$, there are four non-zero elements in total. The row number vector is (0 1 2 2), the column number vector is (2 0 1 2), and the numeric vector is (1 2 3 4).

Manner 3: compressed sparse row format (compressed sparse row format, CSR) compression.

In the CSR compression manner, a non-zero element in each original matrix is represented by three types of data, namely, a numeric vector, a column number vector, and a row offset vector. The numeric vector and the column number vector are consistent with those in the COO compression method. A first piece of data in the row offset vector represents a location of a first element in a row 1 of all non-zero elements. For example, for a matrix C, non-zero data in the row 1 is 1, which is the first piece of data in a non-zero element. If the location is 0, the first piece of data in the row offset vector is 0. A second piece of data in the row offset vector represents a location of the first element in a row 2 in all non-zero elements. For example, for the matrix C, the non-zero data of the row 2 is 2, which is the second piece of data in the non-zero element. If the location is 1, the second piece of data in the row offset vector is 1. By analogy, a last piece of data in the row offset vector is a total number of all non-zero elements. For the matrix C, the row offset vector is (0 1 2 4).

For example, in Example 1, it is assumed that the device 110 includes four to-be-communicated GPUs, which are respectively a GPU 1, a GPU 2, a GPU 3, and a GPU 4, and to-be-communicated matrices on each GPU are as follows:

| GPU 1: | GPU 2: | GPU 3: | GPU 4: |
|--------|--------|--------|--------|
| {1,1,1,1}, | {0,0,0,0}, | {0,0,0,0}, | {0,0,0,0}, |
| {0,0,0,0}, | {3,3,3,3}, | {0,0,0,0}, | {0,0,0,0}, |
| {0,0,0,0}, | {4,4,4,4}, | {0,0,0,0}, | {0,0,0,0}, |
| {0,0,0,0}, | {3,3,3,3}, | {0,0,0,0}, | {0,0,0,0}, |
| {0,0,0,0}, | {0,0,0,0}, | {6,6,6,6}, | {0,0,0,0}, |
| {1,1,1,1}, | {0,0,0,0}, | {0,0,0,0}, | {0,0,0,0}, |
| {0,0,0,0}, | {4,4,4,4}, | {0,0,0,0}, | {0,0,0,0}, |
| {0,0,0,0}, | {0,0,0,0}, | {7,7,7,7}, | {0,0,0,0}, |
| {0,0,0,0}, | {5,5,5,5}, | {0,0,0,0}, | {0,0,0,0}, |
| {0,0,0,0}, | {0,0,0,0}, | {8,8,8,8}, | {0,0,0,0}, |
| {1,1,1,1}, | {0,0,0,0}, | {0,0,0,0}, | {0,0,0,0}, |
| {0,0,0,0}, | {0,0,0,0}, | {6,6,6,6}, | {0,0,0,0}, |
| {1,1,1,1}, | {0,0,0,0}, | {0,0,0,0}, | {0,0,0,0}, |
| {0,0,0,0}, | {3,3,3,3}, | {0,0,0,0}, | {0,0,0,0}, |
| {0,0,0,0}, | {0,0,0,0}, | {0,0,0,0}, | {9,9,9,9}, |
| {0,0,0,0} | {0,0,0,0} | {8,8,8,8} | {0,0,0,0} |

After the row compression is used, to-be-communicated matrices on the GPU 1 to the GPU 4 are respectively as follows:

| GPU 1: | GPU 2: | GPU 3: | GPU 4: |
|--------|--------|--------|--------|
| {1,1,1,1}, | {3,3,3,3}, | {6,6,6,6}, | {9,9,9,9}, |
| {1,1,1,1}, | {4,4,4,4}, | {7,7,7,7}, | |
| {1,1,1,1}, | {3,3,3,3}, | {8,8,8,8}, | |
| {1,1,1,1} | {4,4,4,4}, | {6,6,6,6}, | |
| | {5,5,5,5}, | {8,8,8,8} | |
| | {3,3,3,3}, | | |

A communication vector of each GPU is as follows:

| GPU 1: | GPU 2: | GPU 3: | GPU 4: |
|--------|--------|--------|--------|
| {0,5,10,11,16} | {1,2,3,6,8,12,16} | {4,7,9,11,15,16} | {14,16} |

S402. Establish a communication channel between to-be-communicated computing chips.

The communication channel is established based on a quantity of to-be-communicated computing chips, so that a quantity of communication channels is equal to the quantity of to-be-communicated computing chips. Each communication channel transmits some data of the to-be-communicated matrix. Data of the to-be-communicated matrix before compression may be evenly allocated to each communication channel based on a quantity of rows. Optionally, a quantity of rows of the to-be-communicated matrix transmitted by each communication channel may be dynamically planned based on actual data transmissions in the communication channel.

For Example 1, four communication channels may be established in an even allocation manner. A first communication channel transmits data from row 0 to row 3 of the to-be-communicated matrix before compression, and a second communication channel transmits data from row 4 to row 7 of the to-be-communicated matrix before compression, and the rest can be deduced by analogy.

S403. The processor 110 determines a root node from the to-be-communicated computing chip.

For a reduce-scatter operation, each communication channel has a root node, and is for receiving and sending data of another computing chip in the communication channel and complete an arithmetic operation. The root node may be specified by a user, or may be selected by the processor 111 based on performance of each computing chip, for example, a quantity of cores, a core frequency, a storage speed, a bit width of a video random access memory, and a capacity. A selection method is not limited in this application.

In Example 1, the GPU 1 may be selected as the root node of a communication channel 1, the GPU 2 may be selected as the root node of a communication channel 2, and the rest can be deduced by analogy.

S404. The root node receives data of another to-be-communicated computing chip, and obtains a collective operation result.

For each communication channel, a to-be-communicated computing chip of a non-root node scans a compressed matrix, and sends data and a row number that belong to the communication channel in the matrix to a root node of the communication channel.

For example, in Example 1, in the communication channel 1, the communication channel 1 transmits data from row 0 to row 3 of the to-be-communicated matrix before compression, and the GPU 1 is a root node of the communication channel 1. In this case, after scanning the compression vector, the GPU 2 can learn that in first four rows of data of the original matrix, there is to-be-communicated data in the rows 1, 2, and 3. The GPU 2 sends the data {3,3,3,3}, {4,4,4,4}, and {3,3,3,3} that are corresponding to the rows 1, 2, and 3 and the row numbers 1, 2, and 3 in the compression matrix to the GPU 1. However, after scanning the compression vector, the GPU 3 and the GPU 4 can learn that there is no to-be-communicated data in the first four rows of data in the original matrix. Therefore, the GPU 3 and the GPU 4 do not need to send the data. A sending method of other communication channels may be deduced by analogy.

The root node may create, a new matrix area in storage space to receive data sent by a computing chip of the non-root node. A quantity of rows of a new matrix is equal to a quantity of rows transmitted by a communication channel. Then, the root node aggregates the data based on the row number with the data of the row based on the original matrix before compression, to obtain a final collective communication reduce-scatter result.

In Example 1, after receiving data {3,3,3,3}, {4,4,4,4}, and {3,3,3,3} and the row numbers 1, 2, and 3, the GPU 1 separately adds {3,3,3,3}, {4,4,4,4}, and {3,3,3,3} to data in rows 0, 1, 2, and 3 of the original matrix. After receiving data {3,3,3,3}, {6,6,6,6}, and {7,7,7,7} and the row numbers 5, 4, and 7, the GPU 2 separately adds the data to data in rows 4, 5, 6, and 7 of the original matrix. Operations of other GPUs may also be deduced by analogy, and the final collective communication reduce-scatter result is as follows:

| GPU 1: | GPU 2: | GPU 3: | GPU 4: |
|---|---|---|---|
| {1,1,1,1}, | {6,6,6,6}, | {5,5,5,5}, | {1,1,1,1}, |
| {3,3,3,3}, | {1,1,1,1}, | {8,8,8,8}, | {3,3,3,3}, |
| {4,4,4,4}, | {4,4,4,4}, | {1,1,1,1}, | {9,9,9,9}, |
| {3,3,3,3}, | {7,7,7,7}, | {6,6,6,6}, | {8,8,8,8} |

Optionally, the root node may directly calculate received data with data of the row corresponding to the original matrix before compression based on the row number, without creating a new storage area. Because the root node can simultaneously receive and calculate data sent by a plurality of computing chips, the data needs to be locked, to avoid performing a plurality of calculations on one piece of data at the same time. The root node may receive one piece of data at a time, and may receive new data only after each piece of data is calculated. Optionally, the root node may also receive a row of data at the same time, and may receive new data only after each row of data is calculated.

According to the foregoing method, in the collective communication method in this application, the to-be-communicated matrix can be compressed before data is sent, so that invalid transmission of 0 on each channel in the reduce-scatter operation is reduced, and efficiency of the reduce-scatter operation is improved.

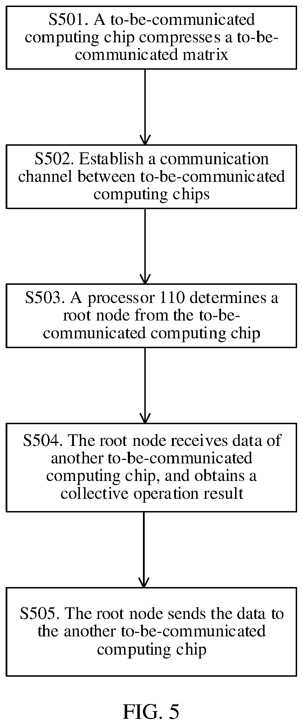

The following describes an all-reduce operation method for collective communication according to an embodiment of this application. FIG. 5 is a schematic flowchart of another collective communication method according to this application. The method may be performed by the device 110 shown in FIG. 1, or may be jointly performed by the device 110 shown in FIG. 1 and another device. The following describes a procedure of the method by using an example in which the device 110 independently performs the method. As shown in FIG. 5, a specific method includes the following steps.

S501. A to-be-communicated computing chip compresses a to-be-communicated matrix, which is similar to S401.

S502. Establish a communication channel between the to-be-communicated computing chips, which is similar to S402.

S503. The processor 110 determines a root node from the to-be-communicated computing chip.

For the all-reduce operation, a same root node may be specified for all communication channels, and is configured to receive and send data of another computing chip and complete an arithmetic operation. A manner of determining a root node is similar to a manner of determining the root node in S403.

In Example 1, the GPU 1 may be selected as the root node.

S504. The root node receives data of another to-be-communicated computing chip, and obtains a collective operation result.

Similar to S404, the root node receives data of another to-be-communicated computing chip and completes calculation. A difference is that in the all-reduce operation, root nodes of all communication channels are a same computing chip. Therefore, finally, one computing chip receives and aggregates data of all to-be-communicated computing chips. In Example 1, a calculation result of the root node GPU 1 is as follows:

GPU 1:
{1,1,1,1},
{3,3,3,3},
{4,4,4,4},
{3,3,3,3},
{6,6,6,6},
{1,1,1,1},
{4,4,4,4},
{7,7,7,7},
{5,5,5,5},
{8,8,8,8},
{1,1,1,1},
{6,6,6,6},
{1,1,1,1},
{3,3,3,3},
{9,9,9,9},
{8,8,8,8}

S505. The root node sends the data to another to-be-communicated computing chip.

The root node sends, in a broadcast form, a matrix obtained in S504 to another to-be-communicated computing chip, to complete the all-reduce operation. In Example 1, an all-reduce result is as follows:

```
GPU 1:        GPU 2:        GPU 3:        GPU 4:
{1,1,1,1},    {1,1,1,1},    {1,1,1,1},    {1,1,1,1},
{3,3,3,3},    {3,3,3,3},    {3,3,3,3},    {3,3,3,3},
{4,4,4,4},    {4,4,4,4},    {4,4,4,4},    {4,4,4,4},
{3,3,3,3},    {3,3,3,3},    {3,3,3,3},    {3,3,3,3},
{6,6,6,6},    {6,6,6,6},    {6,6,6,6},    {6,6,6,6},
{1,1,1,1},    {1,1,1,1},    {1,1,1,1},    {1,1,1,1},
{4,4,4,4},    {4,4,4,4},    {4,4,4,4},    {4,4,4,4},
{7,7,7,7},    {7,7,7,7},    {7,7,7,7},    {7,7,7,7},
{5,5,5,5},    {5,5,5,5},    {5,5,5,5},    {5,5,5,5},
{8,8,8,8},    {8,8,8,8},    {8,8,8,8},    {8,8,8,8},
{1,1,1,1},    {1,1,1,1},    {1,1,1,1},    {1,1,1,1},
{6,6,6,6},    {6,6,6,6},    {6,6,6,6},    {6,6,6,6},
{1,1,1,1},    {1,1,1,1},    {1,1,1,1},    {1,1,1,1},
{3,3,3,3},    {3,3,3,3},    {3,3,3,3},    {3,3,3,3},
{9,9,9,9},    {9,9,9,9},    {9,9,9,9},    {9,9,9,9},
{8,8,8,8}     {8,8,8,8}     {8,8,8,8}     {8,8,8,8}
```

According to the foregoing method, in the collective communication method in this application, the to-be-communicated matrix can be compressed before data is sent. Invalid transmission of 0 on each channel in the all-reduce operation is reduced, thereby improving efficiency of the all-reduce operation.

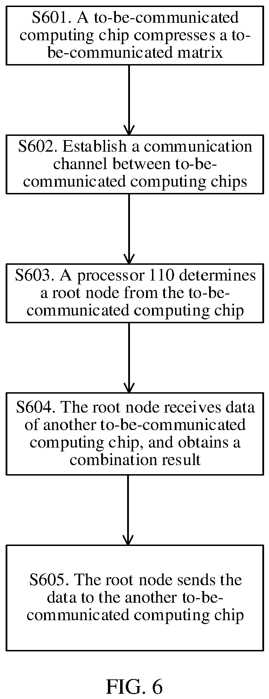

The following describes an all-gather operation method according to an embodiment of this application. FIG. 6 is a schematic flowchart of another collective communication method according to this application. The method may be performed by the device 110 shown in FIG. 1, or may be jointly performed by the device 110 shown in FIG. 1 and another device. The following describes a procedure of the method by using an example in which the device 110 independently performs the method. As shown in FIG. 6, a specific method includes the following steps.

S601. A to-be-communicated computing chip compresses a to-be-communicated matrix, which is similar to S401.

S602. Establish a communication channel between the to-be-communicated computing chips, which is similar to S402.

S603. The processor 110 determines a root node from the to-be-communicated computing chip.

For the all-gather operation, a same root node may be specified for all communication channels, and is configured to receive and send data of another computing chip. A manner of determining a root node is similar to a manner of determining the root node in S403.

In Example 1, the GPU 1 may be selected as the root node.

S604. The root node receives data of another to-be-communicated computing chip, and obtains a combination result.

The another to-be-communicated computing chip may send a compression matrix and a compression vector to the root node. In Example 1, the following may be obtained:

GPU 1:
{1,1,1,1},
{1,1,1,1},
{1,1,1,1},
{1,1,1,1},
{3,3,3,3},
{4,4,4,4},
{3,3,3,3},
{4,4,4,4},
{5,5,5,5},
{3,3,3,3},
{6,6,6,6},
{7,7,7,7},
{8,8,8,8},
{6,6,6,6},
{8,8,8,8},
{9,9,9,9},

Correspondingly, all compression vectors may also be obtained:

GPU 1:
{0,5,10,11,16}
{1,2,3,6,8,12,16}
{4,7,9,11,15,16}
{14,16}

After obtaining the compression matrix and the compression vector, the root node creates a new matrix in storage space of a chip to store a final collective communication result. A quantity of rows of the new matrix is equal to a product of a total quantity of rows of the compression vector and a quantity of communication channels. Then, the root node sequentially fills each non-zero row of the compression matrix into the new matrix based on the quantity of rows of the compression vector. Finally, rows that are not filled with data are filled with 0.

The GPU 1 in Example 1 is used as an example. The GPU 1 first creates a new matrix with 64 rows and 4 columns in the storage space of the chip, and then sequentially fills non-zero rows in S603 into the new matrix based on the compression vector. For example, if a row number of a row 1 {1,1,1,1} in the compression vector is 0, { 1,1,1,1} is filled in a row 0 in a new matrix. If the row number of a row 2 {1,1,1,1} in the compression vector is 5, {1,1,1,1} is filled in a row 5 in the new matrix, and so on. Finally, rows that are not filled with data are filled with 0, and a result of the GPU 1 may be obtained:

```
GPU 1:
(1,1,1,1),
{0,0,0,0},
{0,0,0,0},
{0,0,0,0},
{0,0,0,0},
{1,1,1,1},
{0,0,0,0},
{0,0,0,0},
{0,0,0,0},
{0,0,0,0},
{1,1,1,1},
{0,0,0,0},
{1,1,1,1},
{0,0,0,0},
{0,0,0,0},
{0,0,0,0}
```

```
{0,0,0,0},
{3,3,3,3},
{4,4,4,4},
{3,3,3,3},
{0,0,0,0},
{0,0,0,0},
{4,4,4,4},
{0,0,0,0},
{5,5,5,5},
{0,0,0,0},
{0,0,0,0},
{0,0,0,0},
{3,3,3,3},
{0,0,0,0},
{0,0,0,0}
{0,0,0,0},
{0,0,0,0},
{0,0,0,0},
{0,0,0,0},
{6,6,6,6},
{0,0,0,0},
{0,0,0,0},
{7,7,7,7},
{0,0,0,0},
{8,8,8,8},
{0,0,0,0},
{6,6,6,6},
{0,0,0,0},
{0,0,0,0},
{0,0,0,0},
{8,8,8,8}
{0,0,0,0},
{0,0,0,0},
{0,0,0,0},
{0,0,0,0},
{0,0,0,0},
{0,0,0,0},
{0,0,0,0},
{0,0,0,0},
{0,0,0,0},
{0,0,0,0},
{0,0,0,0},
{0,0,0,0},
{0,0,0,0},
{9,9,9,9},
{0,0,0,0}
```

S605. The root node sends the data to another to-be-communicated computing chip.

Similar to S505, the root node sends, in a broadcast form, a matrix obtained in S604 to another to-be-communicated computing chip, to complete the all-gather operation.

According to the foregoing method, in the collective communication method in this application, the to-be-communicated matrix can be compressed before data is sent, so that invalid transmission of 0 in the all-gather operation is reduced, and efficiency of the all-gather operation is improved.

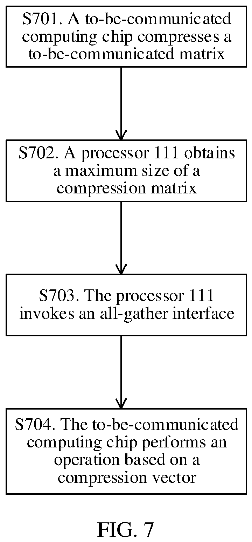

For a GPU collective communication library NCCL® device that has NVIDIA® installed, operations may be further performed based on collective operations provided in the NCCL® communication library. FIG. 7 is a schematic flowchart of another collective communication method according to this application. Specifically, an all-reduce operation may be performed. The method may be performed by the device 110 shown in FIG. 1, or may be jointly performed by the device 110 shown in FIG. 1 and another device. The following describes a procedure of the method by using an example in which the device 110 independently performs the method. As shown in FIG. 7, a specific method includes the following steps.

12

S701. A to-be-communicated computing chip compresses a to-be-communicated matrix, which is similar to S401.

S702. A processor 111 obtains a maximum size of a compression matrix.

The processor 111 may directly invoke an interface of an all-reduce function in an NCCL® communication library to obtain a quantity of rows of a compression matrix on each to-be-communicated computing chip. Optionally, each to-be-communicated computing chip may further traverse the compression matrix, and send the quantity of rows to the processor 111. Optionally, each to-be-communicated computing chip may further directly read the quantity of rows from a compression vector, and send the quantity of rows to the processor 111.

The processor 111 fills, based on a maximum value of the quantity of rows, a compression matrix in which the quantity of rows does not reach the maximum value on the computing chip with 0, so that the quantity of rows reaches the maximum value. A compressed matrix in Example 1 is used as an example. The quantity of rows of the GPU 1 to the GPU 4 are respectively 4, 6, 5, and 1. A quantity of rows of the GPU 2 is the largest. Therefore, the remaining GPUs fill the quantity of rows with 6 by using data 0. A result is as follows:

| GPU 1: | GPU 2: | GPU 3: | GPU 4: |
|--------|--------|--------|--------|
| {1,1,1,1}, | {3,3,3,3}, | {6,6,6,6}, | {9,9,9,9}, |
| {1,1,1,1}, | {4,4,4,4}, | {7,7,7,7}, | {0,0,0,0}, |
| {1,1,1,1}, | {3,3,3,3}, | {8,8,8,8}, | {0,0,0,0}, |
| {1,1,1,1}, | {4,4,4,4}, | {6,6,6,6}, | {0,0,0,0}, |
| {0,0,0,0}, | {5,5,5,5}, | {8,8,8,8}, | {0,0,0,0}, |
| {0,0,0,0} | {3,3,3,3}, | {0,0,0,0} | {0,0,0,0} |

S703. The processor 111 invokes an all-gather interface.

The processor 111 may invoke the all-gather interface in the NCCL® communication library to send the compression matrix and the compression vector that are on each to-be-communicated GPU to each other to another computing chip, so that each computing chip can obtain all the compression matrices. In Example 1, the following may be obtained:

|  | GPU 1: | GPU 2: | GPU 3: | GPU 4: |
|---|---|---|---|---|
|  | {1,1,1,1}, | {1,1,1,1}, | {1,1,1,1}, | {1,1,1,1}, |
|  | {1,1,1,1}, | {1,1,1,1}, | {1,1,1,1}, | {1,1,1,1}, |
|  | {1,1,1,1}, | {1,1,1,1}, | {1,1,1,1}, | {1,1,1,1}, |
|  | {1,1,1,1}, | {1,1,1,1}, | {1,1,1,1}, | {1,1,1,1}, |
|  | {0,0,0,0}, | {0,0,0,0}, | {0,0,0,0}, | {0,0,0,0}, |
|  | {0,0,0,0}, | {0,0,0,0}, | {0,0,0,0}, | {0,0,0,0}, |
|  | {3,3,3,3}, | {3,3,3,3}, | {3,3,3,3}, | {3,3,3,3}, |
|  | {4,4,4,4}, | {4,4,4,4}, | {4,4,4,4}, | {4,4,4,4}, |
|  | {3,3,3,3}, | {3,3,3,3}, | {3,3,3,3}, | {3,3,3,3}, |
|  | {4,4,4,4}, | {4,4,4,4}, | {4,4,4,4}, | {4,4,4,4}, |
|  | {5,5,5,5}, | {5,5,5,5}, | {5,5,5,5}, | {5,5,5,5}, |
|  | {3,3,3,3}, | {3,3,3,3}, | {3,3,3,3}, | {3,3,3,3}, |
|  | {6,6,6,6}, | {6,6,6,6}, | {6,6,6,6}, | {6,6,6,6}, |
|  | {7,7,7,7}, | {7,7,7,7}, | {7,7,7,7}, | {7,7,7,7}, |
|  | {8,8,8,8}, | {8,8,8,8}, | {8,8,8,8}, | {8,8,8,8}, |
|  | {6,6,6,6}, | {6,6,6,6}, | {6,6,6,6}, | {6,6,6,6}, |
|  | {8,8,8,8}, | {8,8,8,8}, | {8,8,8,8}, | {8,8,8,8}, |
|  | {0,0,0,0}, | {0,0,0,0}, | {0,0,0,0}, | {0,0,0,0}, |
|  | {9,9,9,9}, | {9,9,9,9}, | {9,9,9,9}, | {9,9,9,9}, |
|  | {0,0,0,0}, | {0,0,0,0}, | {0,0,0,0}, | {0,0,0,0}, |
|  | {0,0,0,0}, | {0,0,0,0}, | {0,0,0,0}, | {0,0,0,0}, |
|  | {0,0,0,0}, | {0,0,0,0}, | {0,0,0,0}, | {0,0,0,0}, |
|  | {0,0,0,0}, | {0,0,0,0}, | {0,0,0,0}, | {0,0,0,0}, |
|  | {0,0,0,0} | {0,0,0,0} | {0,0,0,0} | {0,0,0,0} |

Corresponding to each GPU, all compression vectors may also be obtained:

| GPU 1: | GPU 2: | GPU 3: | GPU 4: |
|---|---|---|---|
| {0,5,10,11,16} | {0,5,10,11,16} | {0,5,10,11,16} | {0,5,10,11,16} |
| {1,2,3,6,8,12,16} | {1,2,3,6,8,12,16} | {1,2,3,6,8,12,16} | {1,2,3,6,8,12,16} |
| {4,7,9,11,15,16} | {4,7,9,11,15,16} | {4,7,9,11,15,16} | {4,7,9,11,15,16} |
| {14,16} | {14,16} | {14,16} | {14,16} |

S704. The to-be-communicated computing chip performs an operation based on the compression vector.

After obtaining the compression matrix and the compression vector, the computing chip creates a new matrix in storage space of the chip to store a final collective communication result. A quantity of rows of the new matrix is equal to a total quantity of rows of the compression vector. Then, the computing chip sequentially fills each non-zero row of the compression matrix into the new matrix based on the quantity of rows of the compression vector. If two rows of data in the compression matrix correspond to a same row number, the computing chip fills a computing result of the two rows of data into the new matrix in an operation manner.

The GPU 1 in Example 1 is used as an example. The GPU 1 first creates a new matrix with 16 rows and 4 columns in the storage space of the chip, and then sequentially fills non-zero rows in S703 into the new matrix based on the compression vector. For example, if a row number of a row 1 { 1,1,1,1} in the compression vector is 0, { 1,1,1,1} is filled in a row 0 in a new matrix. If the row number of a row 2 {1,1,1,1} in the compression vector is 5, {1,1,1,1} is filled in a row 5 in the new matrix, and so on. Finally, an all-reduce result of all GPUs may be obtained:

| GPU 1: | GPU 2: | GPU 3: | GPU 4: |
|---|---|---|---|
| {1,1,1,1}, | {1,1,1,1}, | {1,1,1,1}, | {1,1,1,1}, |
| {3,3,3,3}, | {3,3,3,3}, | {3,3,3,3}, | {3,3,3,3}, |
| {4,4,4,4}, | {4,4,4,4}, | {4,4,4,4}, | {4,4,4,4}, |
| {3,3,3,3}, | {3,3,3,3}, | {3,3,3,3}, | {3,3,3,3}, |
| {6,6,6,6}, | {6,6,6,6}, | {6,6,6,6}, | {6,6,6,6}, |
| {1,1,1,1}, | {1,1,1,1}, | {1,1,1,1}, | {1,1,1,1}, |
| {4,4,4,4}, | {4,4,4,4}, | {4,4,4,4}, | {4,4,4,4}, |
| {7,7,7,7}, | {7,7,7,7}, | {7,7,7,7}, | {7,7,7,7}, |
| {5,5,5,5}, | {5,5,5,5}, | {5,5,5,5}, | {5,5,5,5}, |
| {8,8,8,8}, | {8,8,8,8}, | {8,8,8,8}, | {8,8,8,8}, |
| {1,1,1,1}, | {1,1,1,1}, | {1,1,1,1}, | {1,1,1,1}, |
| {6,6,6,6}, | {6,6,6,6}, | {6,6,6,6}, | {6,6,6,6}, |
| {1,1,1,1}, | {1,1,1,1}, | {1,1,1,1}, | {1,1,1,1}, |
| {3,3,3,3}, | {3,3,3,3}, | {3,3,3,3}, | {3,3,3,3}, |
| {9,9,9,9}, | {9,9,9,9}, | {9,9,9,9}, | {9,9,9,9}, |
| {8,8,8,8} | {8,8,8,8} | {8,8,8,8} | {8,8,8,8} |

According to the foregoing method, in the collective communication method in this application, an existing communication library can be directly invoked, and an operation is simple. In addition, invalid transmission of 0 on each channel in an all-reduce operation can be reduced by compressing a matrix, thereby improving efficiency of the all-reduce operation.

In a recommendation system, because data of a user feature and data of a merchandise feature include a large amount of data with a value of 0 and having extremely high sparseness, embedding (embedding) is a core operation of the recommendation system. The embedding operation is mainly used for using a matrix to convert a sparse vector (when a quantity of elements with a value of 0 in a vector is greater than a quantity of elements with a value of non-zero, the vector is called a sparse vector) into a dense vector. A converted vector is referred to as an embedding vector (embedding vector), and the matrix used for conversion is referred to as an embedding table (embedding table). For example, in formula 1, two 5-dimensional characteristic vectors are converted into two 3-dimensional vectors:

$$\begin{pmatrix}1 & 0 & 1 & 0 & 0 \\ 0 & 1 & 0 & 0 & 0\end{pmatrix} \begin{pmatrix} w_{11} & w_{12} & w_{13} \\ w_{21} & w_{21} & w_{23} \\ w_{31} & w_{32} & w_{33} \\ w_{41} & w_{41} & w_{43} \\ w_{51} & w_{52} & w_{53} \end{pmatrix} = \begin{pmatrix} w_{11}+w_{31} & w_{12}+w_{32} & w_{13}+w_{33} \\ w_{21} & w_{21} & w_{23} \end{pmatrix} \qquad \text{Formula 1}$$

In the recommendation system, each iteration of training a recommendation model may include two processes: forward propagation and backpropagation. The forward propagation is used for obtaining a result obtained after conversion of the embedding table and calculation of the recommendation model are performed on input data. Backpropagation is used for obtaining the recommendation model and update of the embedding table based on a difference between a calculated result and an actual value.

With increasing complexity of a model and an increasing amount of data, a size of the embedding table has reached a level of 100 GB to TB, and a level of 10 TB is coming. Because an amount of data of a complete embedding table is excessively large, the data is generally stored by a plurality of computing chips, and each computing chip stores a part of the data of the embedding table. Therefore, in a forward propagation process, a used embedding vector needs to be queried from embedding tables stored in the plurality of computing chips based on a query vector (batch), and data of a corresponding row needs to be obtained. An embedding vector in this iteration process may be combined through a reduce-scatter or all-reduce operation in collective communication. Finally, the embedding vector is input into the recommendation model for training.

In addition, because a calculation amount is excessively large, the recommendation model is stored in different computing chips. After each iteration of calculation, each computing chip can obtain only a part of updated values of the embedding vector. Therefore, in a backpropagation process, the updated values of the embedding vector may be summarized and sent to all computing chips through an all-gather operation in the collective communication, to obtain final updated values of the embedding table.

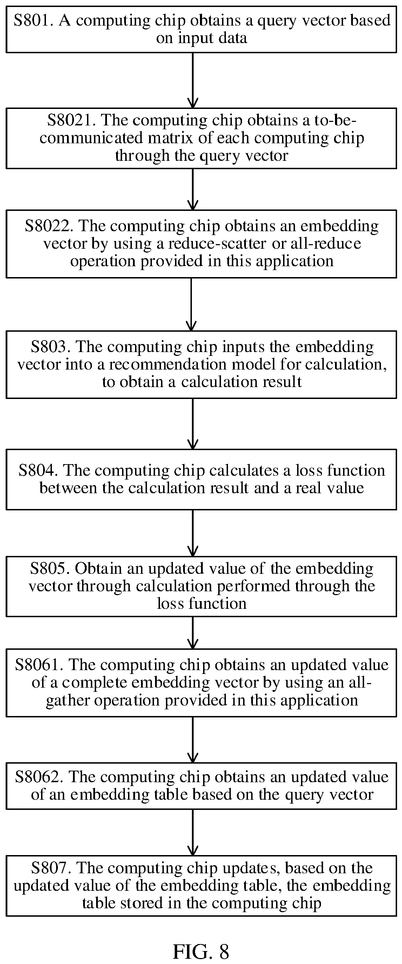

FIG. 8 is a schematic flowchart of another collective communication method according to this application. The method may be performed by the device 110 shown in FIG. 1, or may be jointly performed by the device 110 shown in FIG. 1 and another device. The following describes a procedure of the method by using an example in which the device 110 independently performs the method. As shown in FIG. 8, a specific method is as follows:

S801. A computing chip obtains a query vector based on a user feature and a merchandise feature.

The query vector stores a correspondence between rows of an embedding table and rows of an embedding vector. An amount of data in the query vector is a quantity of rows of the embedding vector, a location of each piece of data is a row of the embedding vector, and a size of each piece of data is a row of the embedding table. For example, when the query vector is { 1,2,3,4}, the embedding vector is a 4-row matrix. A first piece of data is 1, indicating that a row 1 of the embedding vector is data in a row 1 of the embedding table. A second piece of data is 2, indicating that a row 2 of the embedding vector is data in a row 2 of the embedding table.

S802. The computing chip obtains the embedding vector from the embedding table based on the query vector.

Specifically, this step can be divided into two steps, including:

S8021. The computing chip obtains a to-be-communicated matrix of each computing chip through the query vector.

Each computing chip may first create a to-be-communicated matrix in which all data is 0. A quantity of rows in the to-be-communicated matrix is equal to a total amount of data in the query vector. In this case, each computing chip extracts data of a corresponding row from a locally stored embedding table based on the data in the query vector, to form a to-be-communicated matrix.

For example, in Example 2, it is assumed that the device 110 includes four to-be-communicated GPUs, which are respectively a GPU 1, a GPU 2, a GPU 3, and a GPU 4, and embedding tables stored in each GPU are respectively:

| GPU 1: | GPU 2: | GPU 3: | GPU 4: |
|---|---|---|---|
| 1{0,0,0,0}, | 4{3,3,3,3}, | 7{6,6,6,6}, | 10{9,9,9,9}, |
| 2{1,1,1,1}, | 5{4,4,4,4}, | 8{7,7,7,7}, | 11{10,10,10,10}, |
| 3{2,2,2,2}, | 6{5,5,5,5}, | 9{8,8,8,8}, | 12{11,11,11,11}, |

A number before each GPU matrix represents a row number of the embedding table. For the GPU 1, rows 1, 2, and 3 of a complete embedding table are stored, and data in each row is {0,0,0,0}, {1,1,1,1}, and {2,2,2,2}.

It is assumed that the query vector is: {2,4,5,4,7,2,5,8,6,9,2,7,2,4,10,9}, 16 rows in total. The GPU 1 to the GPU 4 first separately create a matrix of 16 rows and 4 columns in which all data is 0. Based on the query vector, if a row 2 of the embedding table is corresponding to rows 1, 6, 11, and 13 of the embedding vector, the GPU 1 extracts data of the row 2 from the locally stored embedding table, and fills the data of the row 2 into the rows 1, 6, 11, and 13 of the matrix respectively. A row 4 of the embedding table corresponds to rows 2, 4, and 14 of the embedding vector. A row 5 of the embedding table corresponds to rows 3 and 7 of the embedding vector. A row 6 of the embedding table corresponds to a row 6 of the embedding vector. In this case, the GPU 2 extracts data of the row 4 from the locally stored embedding table and fills the data into the rows 2, 4, and 14 of the matrix, extracts data of the row 5 and fills the data into the rows 3 and 7 of the matrix, and extracts data of the row 6 and fills the data into the row 6 of the matrix, and so on. Finally, to-be-communicated matrices of each GPU are obtained:

|  | GPU 1: | GPU 2: | GPU 3: | GPU 4: |
|---|---|---|---|---|
|  | {1,1,1,1}, | {0,0,0,0}, | {0,0,0,0}, | {0,0,0,0}, |
|  | {0,0,0,0}, | {3,3,3,3}, | {0,0,0,0}, | {0,0,0,0}, |
|  | {0,0,0,0}, | {4,4,4,4}, | {0,0,0,0}, | {0,0,0,0}, |
|  | {0,0,0,0}, | {3,3,3,3}, | {0,0,0,0}, | {0,0,0,0}, |
|  | {0,0,0,0}, | {0,0,0,0}, | {6,6,6,6}, | {0,0,0,0}, |
|  | {1,1,1,1}, | {0,0,0,0}, | {0,0,0,0}, | {0,0,0,0}, |
|  | {0,0,0,0}, | {4,4,4,4}, | {0,0,0,0}, | {0,0,0,0}, |
|  | {0,0,0,0}, | {0,0,0,0}, | {7,7,7,7}, | {0,0,0,0}, |
|  | {0,0,0,0}, | {5,5,5,5}, | {0,0,0,0}, | {0,0,0,0}, |
|  | {0,0,0,0}, | {0,0,0,0}, | {8,8,8,8}, | {0,0,0,0}, |
|  | {1,1,1,1}, | {0,0,0,0}, | {0,0,0,0}, | {0,0,0,0}, |
|  | {0,0,0,0}, | {0,0,0,0}, | {6,6,6,6}, | {0,0,0,0}, |
|  | {1,1,1,1}, | {0,0,0,0}, | {0,0,0,0}, | {0,0,0,0}, |
|  | {0,0,0,0}, | {3,3,3,3}, | {0,0,0,0}, | {0,0,0,0}, |
|  | {0,0,0,0}, | {0,0,0,0}, | {0,0,0,0}, | {9,9,9,9}, |
|  | {0,0,0,0} | {0,0,0,0} | {8,8,8,8} | {0,0,0,0} |

S8022. The computing chip obtains the embedding vector by using the reduce-scatter or all-reduce operation provided in this application.

When a recommendation model is divided into a plurality of parts, and training is separately performed by a plurality of computing chips, the reduce-scatter operation provided in FIG. 4 in this application may be used. Each communicating computing chip may obtain a part of values of the embedding vector, and input the part of values into the recommendation model on the computing chip to perform a next step of calculation.

When the recommendation model is completely trained by one computing chip or by a plurality of computing chips at the same time, the all-reduce operation provided in FIG. 5 or FIG. 7 in this application may be used for obtaining a complete embedding vector. The embedding vector is input into the recommendation model for next calculation.

S803. The computing chip inputs the embedding vector into the recommendation model for calculation, to obtain a calculation result.

S804. Calculate a loss function between the calculation result and a real value.

S805. Obtain an updated value of the embedding vector through calculation performed through the loss function.

S806. The computing chip obtains an updated value of the embedding table based on the updated value of the embedding vector.

Specifically, this step can be divided into two steps, including:

S8061. The computing chip obtains an updated value of the complete embedding vector by using the all-gather operation provided in this application.

When the recommendation model is divided into a plurality of parts, and training is separately performed by a plurality of computing chips, each computing chip can obtain only a part of updated values of the embedding vector. The all-gather operation provided in FIG. 6 in this application may be used, so that each computing chip obtains the updated value of the complete embedding vector.

Example 2 is used as an example. It is assumed that updated values of the embedding vector obtained on four GPUs are respectively:

|  | GPU 1: | GPU 2: | GPU 3: | GPU 4: |
|---|---|---|---|---|
|  | {0.1,0.1,0.1,0.1}, | {0.2,0.2,0.2,0.2}, | {0,0,0,0}, | {0.1,0.1,0.1,0.1}, |
|  | {0.1,0.1,0.1,0.1}, | {0.3,0.3,0.3,0.3}, | {0.8,0.8,0.8,0.8}, | {0,0,0,0}, |
|  | {0.2,0.2,0.2,0.2}, | {0,0,0,0}, | {0.1,0.1,0.1,0.1}, | {0.9,0.9,0.9,0.9}, |
|  | {0.3,0.3,0.3,0.3}, | {0.1,0.1,0.1,0.1}, | {0.6,0.6,0.6,0.6}, | {0.8,0.8,0.8,0.8} |

After the all-gather operation provided in FIG. 6 in this application, the following may be obtained:

```
GPU 1:                GPU 2:                GPU 3:                GPU 4:
{0.1,0.1,0.1,0.1},    {0.1,0.1,0.1,0.1},    {0.1,0.1,0.1,0.1},    {0.1,0.1,0.1,0.1},
{0.1,0.1,0.1,0.1},    {0.1,0.1,0.1,0.1},    {0.1,0.1,0.1,0.1},    {0.1,0.1,0.1,0.1},
{0.2,0.2,0.2,0.2},    {0.2,0.2,0.2,0.2},    {0.2,0.2,0.2,0.2},    {0.2,0.2,0.2,0.2},
{0.3,0.3,0.3,0.3},    {0.3,0.3,0.3,0.3},    {0.3,0.3,0.3,0.3},    {0.3,0.3,0.3,0.3},
{0.2,0.2,0.2,0.2},    {0.2,0.2,0.2,0.2},    {0.2,0.2,0.2,0.2},    {0.2,0.2,0.2,0.2},
{0.3,0.3,0.3,0.3},    {0.3,0.3,0.3,0.3},    {0.3,0.3,0.3,0.3},    {0.3,0.3,0.3,0.3},
{0,0,0,0},            {0,0,0,0},            {0,0,0,0},            {0,0,0,0},
{0.1,0.1,0.1,0.1},    {0.1,0.1,0.1,0.1},    {0.1,0.1,0.1,0.1},    {0.1,0.1,0.1,0.1},
{0,0,0,0},            {0,0,0,0},            {0,0,0,0},            {0,0,0,0},
{0.8,0.8,0.8,0.8},    {0.8,0.8,0.8,0.8},    {0.8,0.8,0.8,0.8},    {0.8,0.8,0.8,0.8},
{0.1,0.1,0.1,0.1},    {0.1,0.1,0.1,0.1},    {0.1,0.1,0.1,0.1},    {0.1,0.1,0.1,0.1},
{0.6,0.6,0.6,0.6},    {0.6,0.6,0.6,0.6},    {0.6,0.6,0.6,0.6},    {0.6,0.6,0.6,0.6},
{0.1,0.1,0.1,0.1},    {0.1,0.1,0.1,0.1},    {0.1,0.1,0.1,0.1},    {0.1,0.1,0.1,0.1},
{0,0,0,0},            {0,0,0,0},            {0,0,0,0},            {0,0,0,0},
{0.9,0.9,0.9,0.9},    {0.9,0.9,0.9,0.9},    {0.9,0.9,0.9,0.9},    {0.9,0.9,0.9,0.9},
{0.8,.8,0.8,0.8}      {0.8,.8,0.8,0.8}      {0.8,0.8,0.8,0.8}      {0.8,0.8,0.8,0.8}
```

S8062. The computing chip obtains the updated value of the embedding table based on the query vector.

Based on a row of the embedding vector that is in the query vector and that is corresponding to a row of the embedding table stored in each computing chip, an updated value of each row of the embedding table is obtained from the updated value of the embedding vector. When the row of the embedding table corresponds to a plurality of rows of the embedding vector in the query vector, data of all rows of the embedding vector is added up and used as the row of the embedding table.

In Example 2, the query vector is: {2,4,5,4,7,2,5,8,6,9,2,7,2,4,10,9}. A row 2 of the embedding table is corresponding to rows 1, 6, 11, and 13 of the embedding vector. In this case, the GPU 1 extracts data in the rows 1, 6, 11, and 13 from the obtained updated value of the embedding table, {0.1,0.1,0.1,0.1}, {0.3,0.3,0.3,0.3}, {0.8,0.8,0.8,0.8}, and {0.1,0.1,0.1,0.1}, which are added up as an updated value of the row 2 of the embedding table, {1.3,1.3,1.3,1.3}. By analogy, updated values of the embedding table are finally obtained:

```
GPU 1:                GPU 2:                GPU 3:                GPU 4:
{0,0,0,0},            {0.4,0.4,0.4,0.4},    {0.8,0.8,0.8,0.8},    {0.9,0.9,0.9,0.9},
{1.3,1.3,1.3,1.3},    {0.3,0.3,0.3,0.3},    {0.1,0.1,0.1,0.1},    {0,0,0,0},
{0,0,0,0},            {0,0,0,0},            {1.6,1.6,1.6,1.6},    {0,0,0,0},
```

S807. The computing chip updates, based on the updated value of the embedding table, the embedding table stored in the computing chip.

According to the foregoing method, in the collective communication method in this application, a matrix can be compressed in an embedding vector combination process and an embedding table update process, thereby improving efficiency of collective communication and reducing time used in a training process of the recommendation model.

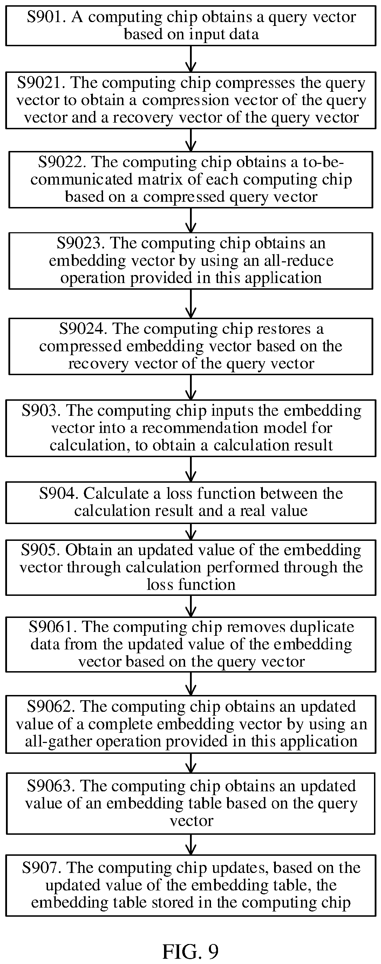

FIG. 9 is a schematic flowchart of another collective communication method according to this application. The method may be performed by the device 110 shown in FIG. 1, or may be jointly performed by the device 110 shown in FIG. 1 and another device. The following describes a procedure of the method by using an example in which the device 110 independently performs the method. Compared with the method in FIG. 8, only steps S902 and S906 in the method in FIG. 9 are different from the steps in FIG. 8, and other steps are similar to the steps in FIG. 8. A specific method is as follows:

S901. A computing chip obtains a query vector based on a user feature and a merchandise feature.

S902. The computing chip obtains the embedding vector from the embedding table based on the query vector.

Specifically, this step can be divided into three steps, including:

S9021. The computing chip compresses the query vector to obtain a compression vector of the query vector and a recovery vector of the query vector.

Repeated elements in the query vector are removed, and a location of each piece of data in a compressed query vector in the query vector before compression is recorded through the recovery vector of the query vector.

As shown in Example 2, the query vector is: {2,4,5,4,7,2,5,8,6,9,2,7,2,4,10,9}. The compressed query vector is {2,4,5,7,8,6,9,10}, and the recovery vector of the query vector is {{1,6,11}, {2,3,14}, {3,7}, {5,12}, {8}, {9}, {10,16}, {15}}, which indicates that 1 appears at locations 1, 6, and 11 of the query vector before compression, 3 appears at locations 2, 4, and 14 of the query vector before compression, and so on.

S9022. The computing chip obtains a to-be-communicated matrix of each computing chip based on the compressed query vector, which is similar to S8021.

In Example 2, to-be-communicated matrices of each GPU may be obtained:

| GPU 1: | GPU 2: | GPU 3: | GPU 4: |
|---|---|---|---|
| {1,1,1,1}, | {0,0,0,0}, | {0,0,0,0}, | {0,0,0,0}, |
| {0,0,0,0}, | {3,3,3,3}, | {0,0,0,0}, | {0,0,0,0}, |
| {0,0,0,0}, | {4,4,4,4}, | {0,0,0,0}, | {0,0,0,0}, |
| {0,0,0,0}, | {0,0,0,0}, | {6,6,6,6}, | {0,0,0,0}, |
| {0,0,0,0}, | {0,0,0,0}, | {7,7,7,7}, | {0,0,0,0}, |
| {0,0,0,0}, | {5,5,5,5}, | {0,0,0,0}, | {0,0,0,0}, |
| {0,0,0,0}, | {0,0,0,0}, | {8,8,8,8}, | {0,0,0,0}, |
| {0,0,0,0}, | {0,0,0,0}, | {0,0,0,0}, | {9,9,9,9} |

S9023. The computing chip obtains a compressed embedding vector by using the all-reduce operation provided in this application.

The all-reduce operation provided in FIG. 5 or FIG. 7 in this application may be used for obtaining the compressed embedding vector. In Example 2, the obtained compressed embedding vector is as follows:

| GPU 1: | GPU 2: | GPU 3: | GPU 4: |
|---|---|---|---|
| {1,1,1,1}, | {1,1,1,1}, | {1,1,1,1}, | {1,1,1,1}, |
| {3,3,3,3}, | {3,3,3,3}, | {3,3,3,3}, | {3,3,3,3}, |
| {4,4,4,4}, | {4,4,4,4}, | {4,4,4,4}, | {4,4,4,4}, |
| {6,6,6,6}, | {6,6,6,6}, | {6,6,6,6}, | {6,6,6,6}, |
| {7,7,7,7}, | {7,7,7,7}, | {7,7,7,7}, | {7,7,7,7}, |
| {5,5,5,5}, | {5,5,5,5}, | {5,5,5,5}, | {5,5,5,5}, |
| {8,8,8,8}, | {8,8,8,8}, | {8,8,8,8}, | {8,8,8,8}, |
| {9,9,9,9}, | {9,9,9,9}, | {9,9,9,9}, | {9,9,9,9}, |

S9024. The computing chip restores the compressed embedding vector based on the recovery vector of the query vector.

The computing chip may first create a new matrix to store a final embedding vector. A quantity of rows of the new matrix is equal to a total amount of data of the query vector before compression. Then, the computing chip sequentially determines a location of data of each row in the compressed embedding vector in the recovery vector of the query vector based on a row number, and further determines a location of the data of the row in an original query vector. Finally, the computing chip fills the data of the row into a final matrix of the embedding vector based on the location in the original query vector.

The GPU 1 in Example 2 is used as an example. The GPU 1 first creates, in storage space of the chip, a matrix with 16 rows and 4 columns of a new embedding vector, and then sequentially determines, based on the compression vector, a location that is in the original query vector and that is corresponding to the data of each row in S9023. For example, if a row number of a row 1 {1,1,1,1} in the compressed embedding vector is 1, the row 1 is a first piece of data in the recovery vector of the query vector. Corresponding data content is {1,6,11}, indicating that data of the row is in rows 1, 6, and 11 in the original query vector. In this case, a computing matrix fills { 1,1,1,1} into rows 1, 6, and 11 of the new matrix, and so on. Finally, an all-reduce result of all GPUs may be obtained:

|   | GPU 1: | GPU 2: | GPU 3: | GPU 4: |
|---|--------|--------|--------|--------|
|   | {1,1,1,1}, | {1,1,1,1}, | {1,1,1,1}, | {1,1,1,1}, |
|   | {3,3,3,3}, | {3,3,3,3}, | {3,3,3,3}, | {3,3,3,3}, |
|   | {4,4,4,4}, | {4,4,4,4}, | {4,4,4,4}, | {4,4,4,4}, |
|   | {3,3,3,3}, | {3,3,3,3}, | {3,3,3,3}, | {3,3,3,3}, |
|   | {6,6,6,6}, | {6,6,6,6}, | {6,6,6,6}, | {6,6,6,6}, |
|   | {1,1,1,1}, | {1,1,1,1}, | {1,1,1,1}, | {1,1,1,1}, |
|   | {4,4,4,4}, | {4,4,4,4}, | {4,4,4,4}, | {4,4,4,4}, |
|   | {7,7,7,7}, | {7,7,7,7}, | {7,7,7,7}, | {7,7,7,7}, |
|   | {5,5,5,5}, | {5,5,5,5}, | {5,5,5,5}, | {5,5,5,5}, |
|   | {8,8,8,8}, | {8,8,8,8}, | {8,8,8,8}, | {8,8,8,8}, |
|   | {1,1,1,1}, | {1,1,1,1}, | {1,1,1,1}, | {1,1,1,1}, |
|   | {6,6,6,6}, | {6,6,6,6}, | {6,6,6,6}, | {6,6,6,6}, |
|   | {1,1,1,1}, | {1,1,1,1}, | {1,1,1,1}, | {1,1,1,1}, |
|   | {3,3,3,3}, | {3,3,3,3}, | {3,3,3,3}, | {3,3,3,3}, |
|   | {9,9,9,9}, | {9,9,9,9}, | {9,9,9,9}, | {9,9,9,9}, |
|   | {8,8,8,8} | {8,8,8,8} | {8,8,8,8} | {8,8,8,8} |

S903. The computing chip inputs the embedding vector into a recommendation model for calculation, to obtain a calculation result.

S904. Calculate a loss function between the calculation result and a real value.

S905. Obtain an updated value of the embedding vector through calculation performed through the loss function.

S906. The computing chip obtains an updated value of the embedding table based on the updated value of the embedding vector.

Specifically, this step can be divided into two steps, including:

S9061. The computing chip removes duplicate data from the updated value of the embedding vector based on the query vector.

Similar to S8061, when the recommendation model is divided into a plurality of parts, and training is separately performed by a plurality of computing chips, each computing chip can obtain only a part of updated values of the embedding vector. As described above, a location of each piece of data in the query vector is a row of the embedding vector, and a size of each piece of data is a row of the embedding table. After the computing chip may traverse data corresponding to locations of rows of a part of the embedding vector in the query vector, updated values of rows that are of the embedding vector and that are corresponding to locations with same values of data in the query vector are added up, to be written into any row of rows corresponding to the embedding vector, and other rows are assigned with 0.

The GPU 1 in Example 2 is used as an example, and updated values of the embedding vector are as follows:

|   | GPU 1: | GPU 2: | GPU 3: | GPU 4: |
|---|--------|--------|--------|--------|
|   | {0.1,0.1,0.1,0.1}, | {0.2,0.2,0.2,0.2}, | {0,0,0,0}, | {0.1,0.1,0.1,0.1}, |
|   | {0.1,0.1,0.1,0.1}, | {0.3,0.3,0.3,0.3}, | {0.8,0.8,0.8,0.8}, | {0,0,0,0}, |
|   | {0.2,0.2,0.2,0.2}, | {0,0,0,0}, | {0.1,0.1,0.1,0.1}, | {0.9,0.9,0.9,0.9}, |
|   | {0.3,0.3,0.3,0.3}, | {0.1,0.1,0.1,0.1}, | {0.6,0.6,0.6,0.6}, | {0.8,0.8,0.8,0.8} |

The query vector is {2,4,5,4,7,2,5,8,6,9,2,7,2,4,10,9}, a part of embedding vector obtained by the GPU 1 is row 1 to row 4 of a complete embedding vector, and the GPU 1 traverses a first to a fourth piece of data {2,4,5,4} of the query vector. Values of the second piece of data and the fourth piece of data are both 4. Therefore, data in the row 2 and the row 4 of the embedding vector in the GPU 1 may be added up, to be written into to the row 2, and the data of the row 4 is assigned with a value 0. By analogy, the updated values of the embedding vector are obtained:

|   | GPU 1: | GPU 2: | GPU 3: | GPU 4: |
|---|--------|--------|--------|--------|
|   | {0.1,0.1,0.1,0.1}, | {0.2,0.2,0.2,0.2}, | {0,0,0,0}, | {0.1,0.1,0.1,0.1}, |
|   | {0.4,0.4,0.4,0.4}, | {0.3,0.3,0.3,0.3}, | {0.8,0.8,0.8,0.8}, | {0,0,0,0}, |
|   | {0.2,0.2,0.2,0.2}, | {0,0,0,0}, | {0.1,0.1,0.1,0.1}, | {0.9,0.9,0.9,0.9}, |
|   | {0,0,0,0}, | {0.1,0.1,0.1,0.1}, | {0.6,0.6,0.6,0.6}, | {0.8,0.8,0.8,0.8} |

Because data of a same value in the query vector corresponds to a same row in the embedding table, a plurality of rows of data of the embedding vector corresponding to the query vector may be converted into one row in advance, thereby increasing sparseness of a to-be-communicated matrix in a next step, and improving collective communication efficiency. When more data is duplicated in the query vector, communication efficiency is improved.

S9062. The computing chip obtains an updated value of a complete embedding vector by using the all-gather operation provided in this application, which is similar to S8062.

S9063. The computing chip obtains the updated value of the embedding table based on the query vector, which is similar to S8062.

S907. The computing chip updates, based on the updated value of the embedding table, the embedding table stored in the computing chip.

According to the foregoing method, in the collective communication method in this application, an embedding vector that needs to be communicated can be compressed to a maximum extent, thereby further reducing an amount of data transmitted in communication, improving efficiency of collective communication, and reducing time used in a training process of the recommendation model.

It should be noted that, for ease of description, the foregoing method embodiments are described as a series of actions. However, a person skilled in the art should appreciate that this application is not limited to the described sequence of the actions.

Another appropriate step combination that can be figured out by a person skilled in the art according to the content described above also falls within the protection scope of this application. In addition, a person skilled in the art should also be familiar to embodiments described in this specification all belong to example embodiments, and involved actions are not necessarily mandatory in this application.

This application further provides a collective communication system, which may be the system 100 shown in FIG. 1. The collective communication system includes at least a first computing chip and a second computing chip. The first computing chip communicates with the second computing chip through at least one communication channel. For example, the first computing chip and the second computing chip may be the computing chip 1131 and the computing chip 1132 shown in FIG. 1, or may be the computing chip 1131 and the computing chip 1231 shown in FIG. 1. The collective communication system is configured to implement the operation steps of the method performed by a corresponding entity in the foregoing collective communication method. According to the foregoing collective communication system, an amount of data between computing chips can be reduced, and collective communication efficiency can be improved. The system may further reduce a computing speed and improve user experience in a scenario of recommending merchandise to a user.

All or some of the foregoing embodiments may be implemented using software, hardware, firmware, or any combination thereof. When software is used to implement embodiments, the foregoing embodiments may be implemented completely or partially in a form of a computer program product. The computer program product includes one or more computer instructions. When the computer program instructions are loaded or executed on a computer, all or some of the processes or the functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, and microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), or a semiconductor medium. The semiconductor medium may be a solid-state drive (solid-state drive, SSD).

The foregoing descriptions are merely specific implementations of this application. Any variation or replacement that can be figured out by a person skilled in the art according to the specific implementations provided in this application shall fall within the protection scope of this application.

## Claims

1. A collective communication method, wherein the method is applied to a collective communication system, the system comprises at least a first computing chip and a second computing chip, the first computing chip communicates with the second computing chip through at least one communication channel, and the method comprises:

   compressing, by the first computing chip, first data;

sending, by the first computing chip, compressed first data to the second computing chip through the communication channel; and

performing, by the second computing chip, an operation based on the compressed first data.

2. The collective communication method according to claim 1, wherein the first computing chip communicates with the second computing chip through one communication channel, the second computing chip is a root node of the communication channel, and the performing, by the second computing chip, an operation based on the compressed first data specifically comprises:

aggregating, by the second computing chip, the first data with compressed second data, wherein the second data is to-be-communicated data on the second computing chip; and

sending, by the second computing chip, an aggregation result to the first computing chip.

3. The collective communication method according to claim 1, wherein the first computing chip communicates with the second computing chip through one communication channel, the second computing chip is a root node of the communication channel, and the performing, by the second computing chip, an operation based on the compressed first data specifically comprises:

combining, by the second computing chip, the first data with compressed second data, wherein the second data is to-be-communicated data on the second computing chip; and

sending, by the second computing chip, a combination result to the first computing chip.

4. The collective communication method according to claim 1, wherein the first computing chip communicates with the second computing chip through a plurality of communication channels, the plurality of communication channels comprise a first communication channel, and the sending, by the first computing chip, compressed first data to the second computing chip through the communication channel specifically comprises:

sending, by the first computing chip, a first part of the first data to the second computing chip through the first communication channel, wherein the second computing chip is a root node of the first communication channel; and

the performing, by the second computing chip, an operation based on the compressed first data specifically comprises:

aggregating, by the second computing chip, a part of the compressed first data with a part of second data, wherein the second data is to-be-communicated data on the second computing chip.

5. The collective communication method according to claim 1, 2, or 4, wherein the collective communication system is configured to recommend merchandise to a user by using a recommendation model with reference to a user feature and a merchandise feature, and before the compressing, by the first computing chip, first data, the method comprises:

converting, by the first processing chip, the user feature and the merchandise feature into the first data based on an embedding table; and

the method further comprises:

inputting, by the second computing chip into the recommendation model, an operation result obtained by the second computing chip by performing an operation based on the compressed first data, to obtain an updated value of the embedding table and an updated value of the recommendation model;

updating, by the second computing chip, the recommendation model based on the updated value of the recommendation model; and

updating, by the second computing chip, the embedding table based on the updated value of the embedding table.

6. The collective communication method according to claim 1 or 3, wherein the collective communication system is configured to recommend merchandise to a user by using a recommendation model with reference to a user feature and a merchandise feature, and before the compressing, by the first computing chip, first data, the method comprises:

converting, by the first processing chip, the user feature and the merchandise feature into fourth data based on an embedding table; and

inputting, by the second computing chip, the fourth data into the recommendation model, to obtain the first data and an updated value of the recommendation model; and
the method further comprises:

updating, by the second computing chip, the recommendation model based on the updated value of the recommendation model; and
updating, by the second computing chip, the embedding table based on an operation result obtained by the second computing chip by performing an operation based on the compressed first data.

7. The collective communication method according to any one of claims 1 to 6, wherein an amount of data whose value is 0 is greater than an amount of data whose value is not 0 in the first data.

8. The collective communication method according to any one of claims 1 to 7, wherein the computing chip comprises one or more of a graphics processing unit, a tensor processing unit, a neural network processing unit, and a deep learning processing unit.

9. A collective communication system, wherein the system comprises at least a first computing chip and a second computing chip, and the first computing chip communicates with the second computing chip through at least one communication channel;

the first computing chip is configured to compress first data, and is further configured to send compressed first data to the second computing chip through the communication channel; and
the second computing chip is configured to perform an operation based on the compressed first data.

10. The collective communication system according to claim 9, wherein the first computing chip communicates with the second computing chip through one communication channel, the second computing chip is a root node of the communication channel, and the second computing chip is further configured to:

aggregate the first data with second data, wherein the second data is to-be-communicated data on the second computing chip; and
send an aggregation result to the first computing chip.

11. The collective communication system according to claim 9, wherein the first computing chip communicates with the second computing chip through one communication channel, the second computing chip is a root node of the communication channel, and the second computing chip is further configured to:

combine the first data with second data, wherein the second data is to-be-communicated data on the second computing chip; and
send a combination result to the first computing chip.

12. The collective communication system according to claim 9, wherein the first computing chip communicates with the second computing chip through a plurality of communication channels, the plurality of communication channels comprise a first communication channel, and the first computing chip is further configured to:

send a first part of the first data to the second computing chip through the first communication channel, wherein the second computing chip is a root node of the first communication channel; and
the second computing chip is further configured to aggregate a part of the compressed first data with a part of second data, wherein the second data is to-be-communicated data on the second computing chip.

13. The collective communication method according to claim 9, 10, or 12, wherein the collective communication system is configured to recommend merchandise to a user by using a recommendation model with reference to a user feature and a merchandise feature, and the first computing chip is further configured to:

before the first computing chip compresses the first data, convert the user feature and the merchandise feature into the first data based on an embedding table; and
the second computing chip is further configured to input, into the recommendation model, an operation result obtained by the second computing chip by performing an operation based on the compressed first data, to obtain an updated value of the embedding table and an updated value of the recommendation model;

update the recommendation model based on the updated value of the recommendation model; and
update the embedding table based on the updated value of the embedding table.

14. The collective communication method according to claim 9 or 11, wherein the collective communication system is configured to recommend merchandise to a user by using a recommendation model with reference to a user feature and a merchandise feature, and the first computing chip is further configured to:

before the first computing chip compresses the first data, convert the user feature and the merchandise feature into fourth data based on an embedding table;
before the first computing chip compresses the first data, the second computing chip is further configured to input the fourth data into the recommendation model, to obtain the first data and an updated value of the recommendation model; and
the second computing chip is further configured to update the recommendation model based on the updated value of the recommendation model; and update the embedding table based on an operation result obtained by the second computing chip by performing an operation based on the compressed first data.

15. The collective communication system according to any one of claims 9 to 14, wherein an amount of data whose value is 0 is greater than an amount of data whose value is not 0 in the first data.

16. The collective communication system according to any one of claims 9 to 15, wherein the computing chip comprises one or more of a graphics processing unit, a tensor processing unit, a neural network processing unit, and a deep learning processing unit.

17. A computer device, comprising a processor, a memory, a first computing chip, and a second computing chip, wherein the memory is configured to store computer-executable instructions, and the processor executes the computer-executable instructions in the memory, so that the first computing chip and the second computing chip perform operation steps of the method according to any one of claims 1 to 8.

18. A computer-readable storage medium, wherein the computer-readable storage medium comprises instructions, and when the instructions are run on a computer, the computer is enabled to perform operation steps of the method according to any one of claims 1 to 8.

Device 110

| Processor 111 | Memory 112 | Communication interface 114 |

Computing chip 1131 · Computing chip 1132

Device 120

| Communication interface 124 | Memory 122 | Processor 121 |

Computing chip 1231 · Computing chip 1232

FIG. 1

FIG. 2

FIG. 3

S401. A to-be-communicated computing chip compresses a to-be-communicated matrix

S402. Establish a communication channel between to-be-communicated computing chips

S403. A processor 110 determines a root node from the to-be-communicated computing chip

S404. The root node receives data of another to-be-communicated computing chip, and obtains a collective operation result

FIG. 4

S501. A to-be-communicated computing chip compresses a to-be-communicated matrix

$\downarrow$

S502. Establish a communication channel between to-be-communicated computing chips

$\downarrow$

S503. A processor 110 determines a root node from the to-be-communicated computing chip

$\downarrow$

S504. The root node receives data of another to-be-communicated computing chip, and obtains a collective operation result

$\downarrow$

S505. The root node sends the data to the another to-be-communicated computing chip

FIG. 5

S601. A to-be-communicated computing chip compresses a to-be-communicated matrix

↓

S602. Establish a communication channel between to-be-communicated computing chips

↓

S603. A processor 110 determines a root node from the to-be-communicated computing chip

↓

S604. The root node receives data of another to-be-communicated computing chip, and obtains a combination result

↓

S605. The root node sends the data to the another to-be-communicated computing chip

FIG. 6

S701. A to-be-communicated computing chip compresses a to-be-communicated matrix

↓

S702. A processor 111 obtains a maximum size of a compression matrix

↓

S703. The processor 111 invokes an all-gather interface

↓

S704. The to-be-communicated computing chip performs an operation based on a compression vector

FIG. 7

S801. A computing chip obtains a query vector based on input data

↓

S8021. The computing chip obtains a to-be-communicated matrix of each computing chip through the query vector

↓

S8022. The computing chip obtains an embedding vector by using a reduce-scatter or all-reduce operation provided in this application

↓

S803. The computing chip inputs the embedding vector into a recommendation model for calculation, to obtain a calculation result

↓

S804. The computing chip calculates a loss function between the calculation result and a real value

↓

S805. Obtain an updated value of the embedding vector through calculation performed through the loss function

↓

S8061. The computing chip obtains an updated value of a complete embedding vector by using an all-gather operation provided in this application

↓

S8062. The computing chip obtains an updated value of an embedding table based on the query vector

↓

S807. The computing chip updates, based on the updated value of the embedding table, the embedding table stored in the computing chip

FIG. 8

S901. A computing chip obtains a query vector based on input data

↓

S9021. The computing chip compresses the query vector to obtain a compression vector of the query vector and a recovery vector of the query vector

↓

S9022. The computing chip obtains a to-be-communicated matrix of each computing chip based on a compressed query vector

↓

S9023. The computing chip obtains an embedding vector by using an all-reduce operation provided in this application

↓

S9024. The computing chip restores a compressed embedding vector based on the recovery vector of the query vector

↓

S903. The computing chip inputs the embedding vector into a recommendation model for calculation, to obtain a calculation result

↓

S904. Calculate a loss function between the calculation result and a real value

↓

S905. Obtain an updated value of the embedding vector through calculation performed through the loss function

↓

S9061. The computing chip removes duplicate data from the updated value of the embedding vector based on the query vector

↓

S9062. The computing chip obtains an updated value of a complete embedding vector by using an all-gather operation provided in this application

↓

S9063. The computing chip obtains an updated value of an embedding table based on the query vector

↓

S907. The computing chip updates, based on the updated value of the embedding table, the embedding table stored in the computing chip

FIG. 9

**INTERNATIONAL SEARCH REPORT**

| International application No. |
|---|
| **PCT/CN2022/075620** |

**A. CLASSIFICATION OF SUBJECT MATTER**

G06F 15/163(2006.01)i

According to International Patent Classification (IPC) or to both national classification and IPC

**B. FIELDS SEARCHED**

Minimum documentation searched (classification system followed by classification symbols)

G06F; G06N; G06Q

Documentation searched other than minimum documentation to the extent that such documents are included in the fields searched

Electronic data base consulted during the international search (name of data base and, where practicable, search terms used)

CNABS, CNTXT, SIPOABS, DWPI: 稀疏, 矩阵, 向量, 数据, 压缩, 传输, 发送, 通信, 规约, 聚合, 合并, 处理, 计算, 节点, sparse, matrix, vector, data, compress, communicate, transmit, send, reduce, gather, process, compute, node, GPU, CPU

**C. DOCUMENTS CONSIDERED TO BE RELEVANT**

| Category* | Citation of document, with indication, where appropriate, of the relevant passages | Relevant to claim No. |
|---|---|---|
| X | CN 111858454 A (SUZHOU INSPUR INTELLIGENT TECHNOLOGY CO., LTD.) 30 October 2020 (2020-10-30)<br>description, paragraphs [0040]-[0090], and figures 1-12 | 1-18 |
| X | CN 112261023 A (SUZHOU INSPUR INTELLIGENT TECHNOLOGY CO., LTD.) 22 January 2021 (2021-01-22)<br>description, paragraphs [0037]-[0071] | 1, 5-9, 13-18 |
| A | CN 112507284 A (TSINGHUA UNIVERSITY) 16 March 2021 (2021-03-16)<br>entire document | 1-18 |
| A | CN 107169098 A (BEIJING JINGDONG SHANGKE INFORMATION TECHNOLOGY CO., LTD. et al.) 15 September 2017 (2017-09-15)<br>entire document | 1-18 |
| A | CN 109409964 A (KOUBEI (SHANGHAI) INFORMATION TECHNOLOGY CO., LTD.) 01 March 2019 (2019-03-01)<br>entire document | 1-18 |
| A | CN 111240744 A (ZHIFUBAO (HANGZHOU) INFORMATION TECHNOLOGY CO., LTD.) 05 June 2020 (2020-06-05)<br>entire document | 1-18 |

☑ Further documents are listed in the continuation of Box C. ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 April 2022** | **24 April 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/075620** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2016179574 A1 (NVIDIA CORP.) 23 June 2016 (2016-06-23)<br>entire document | 1-18 |
| A | US 2018189110 A1 (INTEL CORP.) 05 July 2018 (2018-07-05)<br>entire document | 1-18 |

Form PCT/ISA/210 (second sheet) (January 2015)

## INTERNATIONAL SEARCH REPORT
### Information on patent family members

International application No.

**PCT/CN2022/075620**

| Patent document cited in search report | | | Publication date (day/month/year) | Patent family member(s) | | | Publication date (day/month/year) |
|---|---|---|---|---|---|---|---|
| CN | 111858454 | A | 30 October 2020 | WO | 2022001141 | A1 | 06 January 2022 |
| CN | 112261023 | A | 22 January 2021 | None | | | |
| CN | 112507284 | A | 16 March 2021 | None | | | |
| CN | 107169098 | A | 15 September 2017 | CN | 107169098 | B | 30 June 2020 |
| CN | 109409964 | A | 01 March 2019 | CN | 109409964 | B | 02 June 2020 |
| CN | 111240744 | A | 05 June 2020 | None | | | |
| US | 2016179574 | A1 | 23 June 2016 | TW | 201635143 | A | 01 October 2016 |
| | | | | US | 9928034 | B2 | 27 March 2018 |
| | | | | TW | I656481 | B | 11 April 2019 |
| US | 2018189110 | A1 | 05 July 2018 | EP | 3343387 | A1 | 04 July 2018 |
| | | | | CN | 108268283 | A | 10 July 2018 |
| | | | | US | 10372507 | B2 | 06 August 2019 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110431626